# EUROPEAN PATENT APPLICATION

(11) **EP 4 727 322 A1**
(43) Date of publication of application: **15.04.2026**
(21) Application number: 24823635.8
(22) Date of filing: 07.06.2024
(51) Int. Cl.: H10N 52/80, H10N 52/00, H10N 52/01, H01L 29/82

(54) **METHOD FOR MANUFACTURING SINGLE-CRYSTAL COPPER THIN FILM HAVING NONLINEAR HALL EFFECT AND HOLE CARRIER DOMINANT TRANSPORT PHENOMENON IN TWO-DIMENSIONAL SINGLE-CRYSTAL THIN FILM WITH SUPPRESSED GRAIN BOUNDARY, AND SINGLE-CRYSTAL COPPER THIN FILM AND SINGLE-CRYSTAL COPPER THIN FILM SEMICONDUCTOR MANUFACTURED BY USING SAME**

(30) Priority: 12.06.2023 KR 20230074721; 05.06.2024 KR 20240073380
(71) Applicant: Pusan National University Industry-University Cooperation Foundation, Busan 46241 (KR)
(72) Inventor: JEONG, Se Young, Busan 46241 (KR); KIM, Su Jae, Busan 46241 (KR)
(74) Representative: Gulde & Partner
(86) International application number: PCT/KR2024/007800
(87) International publication number: WO 2024/258115

(57) **Abstract**

The present invention relates to a single crystalline copper thin film and a single crystalline copper thin film semiconductor, which utilize a phenomenon in which holes, rather than electrons, become carriers when a grain boundary (GB) is removed from a copper thin film having a thickness of 200 nm or less. More specifically, the present invention relates to a copper thin film and a single crystalline copper thin film semiconductor, of which electrical properties change to resemble those of a p-type semiconductor under certain conditions. In the single crystalline thin film having a suppressed grain boundary, according to the present invention, a single crystalline copper thin film having a nonlinear hall effect and a hole carrier dominant transport phenomenon includes a single crystalline copper thin film having a thickness of 200 nm or less, wherein the grain boundary is suppressed.

## Description

### TECHNICAL FIELD

The present disclosure relates to a single crystalline copper thin film and a single crystalline copper thin film semiconductor using a phenomenon in which holes, rather than electrons, become carriers when a grain boundary is removed from a copper thin film having a thickness of 200 nm or less, and more particularly, to a copper thin film and a single crystalline copper thin film semiconductor of which electrical properties are changed to resemble those of a p-type semiconductor under certain conditions.

### BACKGROUND ART

It is very well known that carriers in copper are electrons. Copper has the second highest electrical conductivity after silver (Ag) because it exhibits an electron concentration of 10²³/cm³ and a room temperature resistance of 1.72 X 10⁻⁸ Ωcm, and thus copper is mainly used as an electrode or conductor that carries an electric current, and it is difficult to perform a special purpose function.

On the other hand, depending on the type of semiconductor, there are cases where the main carriers are electrons (n-type), but there are also cases where the main carriers are holes (p-type). When an n-type semiconductor and a p-type semiconductor are bonded to form a p-n junction, a flow of current becomes asymmetric, which has important characteristics that can be utilized as an element.

If the characteristics of n-type and p-type can be implemented using only copper, it may be a groundbreaking invention to achieve electrode and element functions using only copper at once without introducing a semiconductor material.

### DISCLOSURE OF INVENTION

### TECHNICAL PROBLEM

The present disclosure has been contrived to solve the foregoing problems, and an aspect of the present disclosure is to manufacture a copper thin film provided to implement n-type and p-type characteristics using only copper by modifying a copper electron orbit to solve a defect of general copper.

Technical problems to be solved in the disclosure are not limited to the above-described problems and other technical problems which are not mentioned will definitely be understood by those skilled in the art from the following description.

### TECHNICAL SOLUTION

### (1) Single crystalline Copper Thin Film

A single crystalline copper thin film having a nonlinear Hall effect and a hole carrier dominant transport phenomenon in a two-dimensional single crystalline thin film with a suppressed grain boundary may include:
a single crystalline copper thin film having a thickness of 200 nm or less, wherein the single crystalline copper thin film has a suppressed grain boundary (GB).

Furthermore, the single crystalline copper thin film may exhibit a nonlinear behavior of Hall resistance according to a magnetic field.

Furthermore, the single crystalline copper thin film may be copper grown by atomic sputtering epitaxy (ASE) on a sapphire substrate.

Furthermore, the single crystalline copper thin film may exhibit a nonlinear behavior of Hall resistance as temperature changes.

### (2) Single crystalline Copper Thin Film Semiconductor

A single crystalline copper thin-film semiconductor may include a single crystalline copper thin film having a thickness of 200 nm or less, wherein the single crystalline copper thin film has a suppressed GB, and electrical properties thereof are modified into p-type.

Furthermore, the single crystalline copper thin film may exhibit a nonlinear behavior of Hall resistance according to a magnetic field.

Furthermore, the single crystalline copper thin film may be copper grown by atomic sputtering epitaxy (ASE) on a sapphire substrate.

Furthermore, the single crystalline copper thin film may exhibit a nonlinear behavior of Hall resistance as temperature changes.

### (3) Method for Manufacturing Single crystalline Copper Thin Film

RF sputtering may be performed on copper at 160 to 180° C to grow and manufacture a copper thin film.

Furthermore, an initial pressure of the RF sputtering may be 2.0×10⁻³ to 2.5×10⁻³ Pa.

Furthermore, the RF sputtering may be performed in an Ar gas atmosphere.

Furthermore, the RF sputtering may control the pressure by injecting Ar gas at 0.3 to 0.7 Pa.

Furthermore, an RF power of the RF sputtering may be 23 to 27 W.

Furthermore, a rotational speed of the RF sputtering may be 25 to 35 RPM.

### ADVANTAGEOUS EFFECTS

By means of the foregoing technical solutions, the present disclosure may solve the defects of general copper to lengthen a mean free path of electrons so as to change a structure of the Fermi surface where the existing electrons reside, thereby modifying an orbit of the electrons.

In addition, the present disclosure may manufacture a copper thin film provided to implement n-type and p-type characteristics using only copper by modifying a copper electron orbit.

### BRIEF DESCRIPTION OF THE DRAWINGS

FIG. 1 is a graph of measuring a Hall effect of general copper or 3D bulk copper.
FIG. 2 is a Fermi surface of 3D copper, which is a ring pattern for inducing an asymmetric magnetoresistance according to forward (a) and reverse (b) directions of current.
FIG. 3 is a surface view of the Fermi surface of 2D copper in a periodic zone scheme.
FIG. 4 shows (a) a Fermi surface obtained from a 2D single crystalline copper thin film through ARPES measurements, and a view (b) showing a result of measurement in a direction of an orange arrow in (a) as an energy axis.
FIG. 5 is graphs of measuring a Hall effect of a single crystalline copper thin film having various thicknesses, including results of measuring a nonlinear Hall effect of a polycrystalline copper (PCCF) having a thickness of 82 nm (a), and a SCCF having a thickness of 205 nm (b), 80 nm (c), 40 nm (d), 12 nm (e), and 10 nm (f).

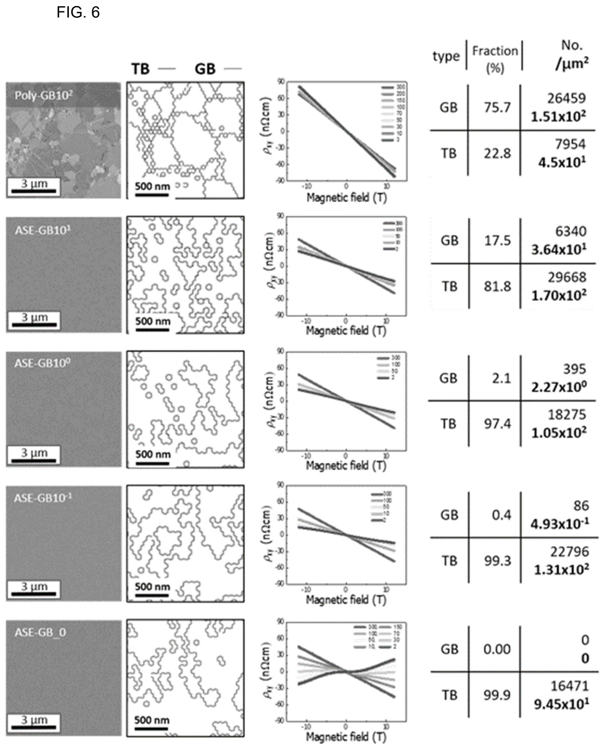

FIG. 6 shows diagrams of EBSD (column 1), misorientation lines (column 2), Hall effect measurements (column 3), and grain boundaries (GBs) and twin boundaries (TBs) (column 4) in a thin film having a thickness of 40 nm, including a polycrystalline thin film (a), a thin film close to a single crystalline grown by an ASE method, with GBs controlled differently (b) to (d), and a completely single crystalline thin film with no grain boundary (e).

### BEST MODE FOR CARRYING OUT THE INVENTION

Terms used herein will be briefly described, and the present disclosure will be described in detail.

Although the terms used in the present disclosure are selected from generally known and used terms considering their functions in the present disclosure, the terms may be modified depending on intention of a person skilled in the art, practices, or the advent of new technology. Accordingly, the terms used herein should be understood not simply by the actual terms used but by the meaning lying within and the description disclosed herein.

Throughout the specification, when a portion may "include" a certain element, unless specified otherwise, it may not be construed to exclude another element but may be construed to further include other elements.

Hereinafter, embodiments of the present disclosure will be described in detail with reference to the accompanying drawings so as to be easily implemented by those skilled in the art. However, the present disclosure may be implemented in various different forms, and is not limited to the embodiments described herein.

Specific details, including the problems to be solved by the present disclosure, means for solving the problems, and effects of the disclosure, are included in the following embodiments and drawings. Advantages and features of the present disclosure, and methods of accomplishing the same will be clearly understood with reference to the following embodiments described in detail in conjunction with the accompanying drawings.

### (1) Single crystalline Copper Thin Film

A single crystalline copper thin film having a nonlinear Hall effect and a hole carrier dominant transport phenomenon in a two-dimensional single crystalline thin film with a suppressed grain boundary according to the present disclosure may include a single crystalline copper thin film having a thickness of 200 nm or less, wherein the single crystalline copper thin film has a suppressed grain boundary. More specifically, it can be seen that a single crystalline copper film having a thickness of 40 nm or less exhibits a most effective suppression of grain boundary.

The single crystalline copper thin film may exhibit a nonlinear behavior of Hall resistance according to a magnetic field.

The single crystalline copper thin film may be copper grown by atomic ASE on a sapphire substrate.

The single crystalline copper thin film may exhibit a nonlinear behavior of Hall resistance as temperature changes.

### (2) Single crystalline Copper Thin Film Semiconductor

It may include a single crystalline copper thin film having a thickness of 200 nm or less, wherein the single crystalline copper thin film has a suppressed grain boundary, and electrical properties thereof are modified into p-type. More specifically, it can be seen that a single crystalline copper film having a thickness of 40 nm or less exhibits a most effective suppression of grain boundary.

The single crystalline copper thin film may exhibit a nonlinear behavior of Hall resistance according to a magnetic field.

The single crystalline copper thin film may be copper grown by atomic ASE on a sapphire substrate.

The single crystalline copper thin film may exhibit a nonlinear behavior of Hall resistance as temperature changes.

### (3) Method for Manufacturing Single crystalline Copper Thin Film

It may be manufactured by performing RF sputtering on copper at 160 to 180° C to grow a copper thin film. More specifically, a copper thin film is preferably grown by RF sputtering at 170° C.

An initial pressure of the RF sputtering may be 2.0×10⁻³ to 2.5×10⁻³ Pa. More specifically, it may be preferably 2.3×10⁻³ Pa.

In addition, the RF sputtering may be performed in an Ar gas atmosphere.

In addition, the RF sputtering may control the pressure by injecting Ar gas at 0.3 to 0.7 Pa. More specifically, it is preferably 0.5 Pa.

In addition, an RF power of the RF sputtering may be 23 to 27 W. More specifically, it is preferably 25 W.

In addition, a rotational speed of the RF sputtering may be 25 to 35 RPM. More specifically, it is preferably 30 RPM.

Hereinafter, the present disclosure will be described in more detail with reference to the accompanying drawings.

The present disclosure relates to a single crystalline copper thin film using a phenomenon in which holes, rather than electrons, become carriers when a grain boundary is removed from a copper thin film having a thickness of 200 nm or less, which is a copper thin film of which electrical properties are changed to resemble those of a p-type semiconductor under certain conditions. This may be performed by completely solving the defects of general copper to lengthen a mean free path of electrons so as to change a structure of the Fermi surface where the existing electrons reside, thereby modifying an orbit of the electrons.

A single crystalline copper thin film having a nonlinear Hall effect and a hole carrier dominant transport phenomenon in a two-dimensional single crystalline thin film with a suppressed grain boundary according to the present disclosure may include a single crystalline copper thin film having a thickness of 200 nm or less, wherein the single crystalline copper thin film has a suppressed grain boundary (hereinafter referred to as a GB).

In addition, the single crystalline copper thin film may exhibit a nonlinear behavior of Hall resistance according to a magnetic field.

In addition, the single crystalline copper thin film may be copper grown by atomic ASE on a sapphire substrate.

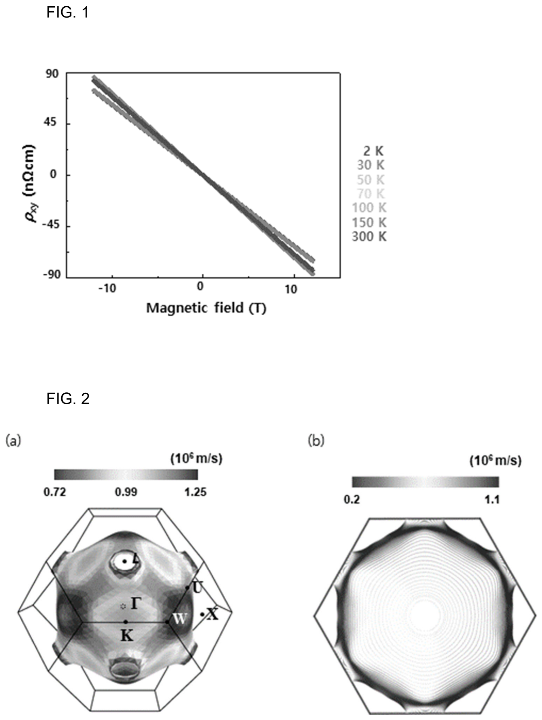

In general, when the Hall effect is measured in copper, it appears linear. This is because there is only one carrier, which means that the Hall resistance increases linearly as the magnetic field increases and there is no significant change with temperature. As shown in FIG. 1, it exhibits a Hall effect of general copper or 3D bulk copper, and it can be seen that the Hall resistance increases linearly as the magnetic field increases.

A solid-state electronic device including transistors, diodes, and various sensors uses the flow and control of conduction electrons in semiconductor channels and metal electrodes. Among the various properties of a material, an electronic band structure near the Fermi surface determines the behavior of conduction electrons, which is a key feature utilized in device applications and designs. Therefore, the polarity, density, and mobility of charge carriers are manipulated and optimized to suit the semiconductor. However, the effective design of electronic properties has not been applied to other important electronic components containing precious metals such as copper (Cu), which conceptually limits the material's overall potential for new devices.

The Fermi surface of metals is overwhelmed by random scattering from numerous defects such as GBs during transport. GBs are difficult to avoid because they are formed at a density of more than ~10² µm⁻² (10¹⁰ cm⁻²) during a metal thin film growth process. Transport of electrons and phonons is reported to be critically affected by GBs, especially when a mean free path (MFP) of the transport medium is longer than a distance between GBs. Additionally, due to reduction in size of modern electronic products, a size of electronic elements is becoming smaller and smaller, and the demand for two-dimensional (2D) electronic materials, including metals, is increasing. Therefore, the synthesis of a single crystalline metal in a 2D shape is an interesting problem. Nucleation in the early growth stage creates countless isolated particles. Although tremendous efforts have been made to minimize GBs in 2D metals, GBs have not been completely suppressed to date, especially for large-scale precious metals (e.g., Cu and Au) up to 10 nm in thickness. GBs created in the initial growth state cause electron scattering, resulting in loss of their unique properties. For example, the resistivity of precious metals increases with decreasing thickness, which is noticeable in the two-dimensional limit. Despite the great interest in 2D materials triggered by the discovery of graphene, the 2D properties of new metals have not yet been well explored. Therefore, thickness control is being made to solve engineering problems such as implementing high conductivity with a minimum amount of metal for fabricating elements. The main physical cause of resistivity variation with thickness is a modified conduction mechanism of the metal along with GB properties. Non-traditional transport of metals may be considered when GB is absent and the thickness is lower than the mean free path (MFP) of the transport medium.

On the other hand, in the single crystalline copper thin film according to the present disclosure, a frequency of electrons colliding with GBs is significantly reduced to lengthen the mean free path so as to allow them to sufficiently orbit an outermost Fermi surface, thereby behaving like holes while orbiting a hole pocket in a reciprocal lattice space.

In the present disclosure, counterintuitive hole carrier dominated (HCD) transport is exhibited in ultraclean 2D copper induced by a combination of a 2D shape and a GB-free growth in a single crystalline thin film (SCCF). A GB density may be strongly suppressed in 2D copper fabricated by an atomic sputtering epitaxy (ASE) system. In the absence of grain boundaries, another category of geometric features, twin boundaries (TBs), may be investigated, which satisfy symmetry compared to GBs and thus do not impede electron transport. Rigorous characterization of the electronic band structure of 2D copper was performed through Hall measurements via structural analysis, angle-resolved photoemission spectroscopy (ARPES) measurements, and two-carrier model fitting analysis. Unlike electron carriers in conventional copper, GB suppression in a 2D single crystalline thin film (SCCF) indicates hole carrier dominated (HCD) transport. First-principles calculations and angle-resolved photoemission spectroscopy (ARPES) measurements experimentally explain HCD transport due to a concave shape of the Fermi surface in 2D copper with zero GB. The unique properties of the transport provide a breakthrough method for manipulating an apparent polarity of charge carriers in metals based on GB engineering in a 2D shape.

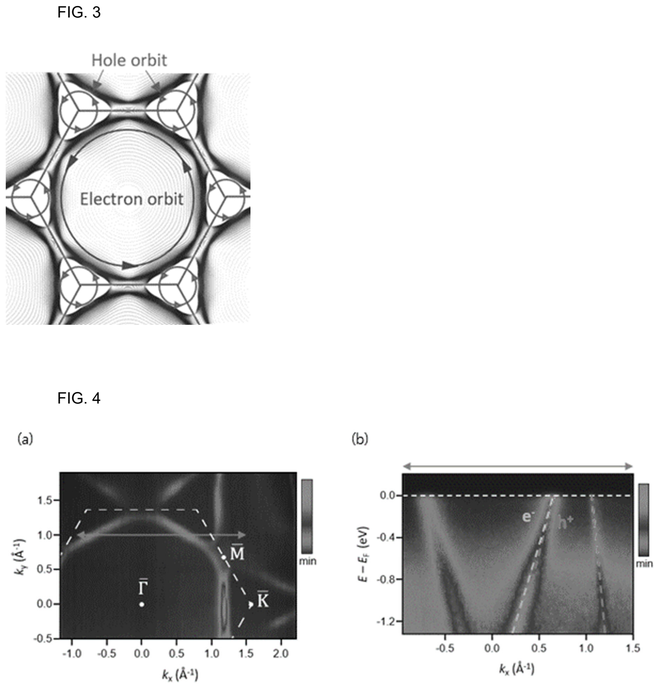

(a) of FIG. 2 shows a Fermi surface of bulk single crystalline copper, and when the bulk (3D) single crystalline copper becomes 2D, it shows a pattern like (b) of FIG. 2. If copper has an ideal single crystalline structure, electrons orbit an outermost surface in (b) of FIG. 2, which becomes a view as shown in FIG. 3 when represented as a diagram of a periodic reciprocal lattice space.

As shown in a blue circle in FIG. 3, electrons orbit in an electron orbit, but electrons orbiting an outermost shell go out to a Fermi surface next thereto through an open orbit to orbit in a hole orbit in a triangle shape. The theoretical calculation results of FIGS. 2 and 3 are also experimentally verified.

(a) of FIG. 4 accurately and experimentally represents a theoretical model of 2D single crystalline copper predicted in FIG. 3. A hexagonal orbit at a bottom in (a) of FIG. 3 represents an electron orbit, and a triangle orbit shown at a right shoulder position or left shoulder position represents a hole orbit. (b) of FIG. 4 is an energy distribution measured in a *kₓ* direction along a direction of an orange arrow in (a) of FIG. 4, where an orbit for electrons (blue dotted line) and an orbit for holes (yellow dotted line) are observed very clearly.

In order to understand the unique properties of 2D copper thin films, an electronic band structure of copper in a 2D limit was calculated. As copper is reduced in thickness along spatial coordinates to a nanometer scale to reach the 2D limit, quantum confinement causes a normal 3D Fermi surface to be reconstructed as in (a) of FIG. 2 and a 2D sub-band surface to be constructed as in (b) of FIG. 2. As a result, a series of 2D Fermi surfaces are created. When copper is thinned along a direction, a peculiar deformation of the 2D Fermi surface results in the formation of concave electron and hole bands, respectively.

Due to a neck along a (111) direction on a 3D Fermi surface, a Fermi surface with a shape near a K-point is predicted as shown in (b) of FIG. 2. A Fermi surface in the center (inner ring) is an electron orbit (scaled by eH/ 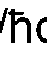 c) with higher potential energy and lower Fermi velocities than the outermost surface, and carriers in this orbit are electrons. An outermost concave Fermi surface has a negative curvature, which allows hole carriers to be generated. This is because conduction carriers moving along convex and concave Fermi surfaces contribute to different polarities based on geometric interpretations of the Fermi surfaces, as previously observed in quasi-2D systems such as YBa₂Cu₃O₇₋ₓ, La₂₋ₓSrₓCuO₄, FeSe, and Ba(Fe₁₋ₓCoₓ)₂As₂. As shown in FIG. 3, it becomes somewhat apparent in a periodic zone system that the 2D FS consists of an electronic pocket at the center of the zone (indicated by a blue circle) and a hole pocket at an edge of the zone (a red circle).

In order to experimentally confirm the reconstruction of the Fermi surface expected through quantum confinement, an electronic structure of a 2D single crystalline thin film (SCCF) having a thickness of 80 nm, which is thin enough to reach a 2D limit at low temperatures was directly measured using ARPES. As expected, the Fermi surface topology taken for the kz = 0 plane ((a) of FIG. 4), which contrasts sharply with the well-known Fermi surface topology of 3D Cu ((a) of FIG. 2), clearly shows two types. The Fermi surfaces (FS), a large hexagonal FS centered at the center of the zone, and a triangular FS around an edge of the zone closely match the calculated FS topology.

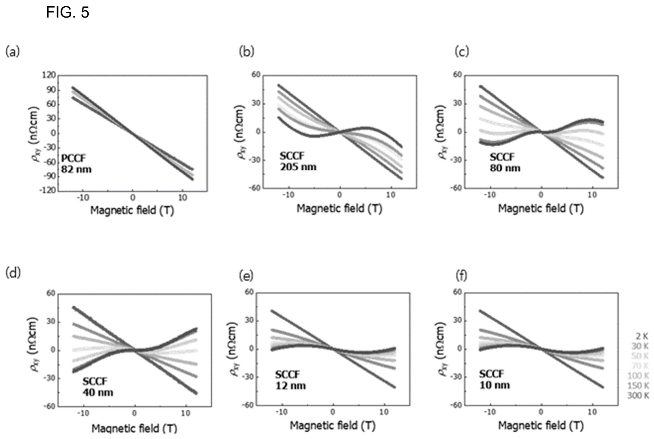

FIG. 5 is a measurement showing how a Hall resistance changes according to a magnetic field through a Hall measurement, and herein, unlike FIG. 1, it shows a nonlinear behavior rather than a straight line. The nonlinear behavior appears more pronounced at lower temperatures. Moreover, the nonlinear behavior appears in a single crystalline copper film starting from a thickness of 200 nm or less, and appears without exception up to a thin film having a thickness of 10 nm. In particular, nonlinearity appears most clearly at a thickness near 40 nm.

As a result of investigating how GBs affect hole behavior using a 40 nm single crystalline copper thin film sample with a most pronounced nonlinearity, the observation of hole carriers in a 2D copper thin film in which GBs have almost disappeared is very clear since nonlinear behavior does not appear in a sample with GBs and nonlinearity is weakened even when a small number of GBs are present.

More specifically, in order to measure a nonlinear Hall effect (NHE) of 2D copper, HCD transport was directly investigated. A Fermi surface of copper originates from an s-band similar to free electrons, whereas fully filled d-electrons do not contribute to an electron band near the Fermi level. The s-band properties of copper ensure sufficiently high conductivity and a Fermi velocity up to 1.1×10⁶ m/s, which is shown in (a) of FIG. 2 through color mapping. As shown in FIG. 1, bulk single crystalline copper thicker than 1 µm shows a general Hall effect having a single carrier (electron) density of n=9.09×10²² cm⁻³ at T=3 K. As shown in (a) of FIG. 5, even if it is a single crystalline, it means that 3D single crystalline copper behaves the same as a polycrystalline copper thin film (PCCF) in a 2D limit.

3D copper also has a concave Fermi surface, but this zone is very narrow and does not lead to purely hole-like orbits in a periodic zone system. Therefore, it is difficult to observe hole carriers in bulk copper. However, a 2D single crystalline thin film (SCCF) sample shows a different behavior in a 2D zone. As shown in (b) to (f) of FIG. 5, as a thickness of a 2D single crystalline thin film (SCCF) sample decreases below 205 nm, a conventional Hall effect, which exhibits a linear response to an external magnetic field, changes to a nonlinear Hall effect (NHE). Here, the nonlinear Hall effect (NHE) represents a deviation from linear dependence on an external magnetic field, called the conventional Hall effect. As shown in (b) of FIG. 5, nonlinearity at low temperatures starts at a thickness of 205 nm, becomes more pronounced at thicknesses of 80 nm ((c) of FIG. 5) and 40 nm ((d) of FIG. 5), and is slightly suppressed at thin samples of 12 nm ((e) of FIG. 5) and 10 nm ((f) of FIG. 5), and approaches the limit of thin film growth.

Hereinafter, the present disclosure will be described in more detail through comparison between comparative examples and embodiments manufactured by conventional methods, and experimental examples. The objectives, features, and advantages of the present disclosure will be easily understood through the following embodiment. The present disclosure is not limited to the embodiments described herein and may be embodied in other forms. The embodiments introduced herein are provided to ensure that the concept of the present disclosure may be sufficiently conveyed to those skilled in the art to which the present disclosure pertains. Therefore, the present disclosure should not be limited by the following embodiments.

### Embodiment 1: Manufacture of Single crystalline Copper Thin Films Using ASE Technology

Cu thin films were fabricated to have high-quality crystallinity with GB-free single crystalline and GB density-controlled single crystalline using ASE technology. An ASE system is a modified RF sputtering system that uses a single crystalline sputtering target, replaces an existing electrical conductor with a single crystalline conductor, and uses a mechanical noise reduction (MNR) system. An optimal growth temperature is approximately 170° C and varies by ± 10° C depending on the system. In order to control GB density, a thin film having a thickness of 40 nm was intentionally grown at 100° C below an optimal temperature, and a number of GBs was controlled through additional heat treatment. A number of GBs and TBs was obtained very accurately through EBSD mapping using a misorientation line distribution in an RD mode. Ar gas (99.9999%, 6N) was used as a deposition atmosphere. A relationship between a deposition time and a thin film thickness (or average growth rate) was determined from an average deposition time of a 200 nm thick film grown under optimal conditions. The determined average growth rate of ~4.3 nm/min is quite reliable for film thicknesses of 10 nm and above. An initial pressure of RF sputtering was 2.3×10⁻³ Pa, and the operating pressure was controlled by injecting argon gas (99.9999%) up to 0.5 Pa. The RF power was 25 W and the rotation speed was 30 RPM. A thickness of the film was controlled by deposition time and confirmed by atomic force microscopy (AFM). An atomic structure of a cross-sectional copper film was observed in an annular dark field (ADF) imaging mode using an aberration-corrected scanning transmission electron microscope (STEM, JEM-ARM200CF, JEOL) operating at 200 kV with a probe forming angle of ~23. An angular range of the ADF detector was set to 45 to 170 mrad.

### Experimental Example 1: Structural Measurement

An EBSD image was obtained using a SUPRA40 VP system (Carl Zeiss AG, Oberkochen, Germany) mounted with a fully automated device attachment device including an EDAX-TSL Hikari EBSD detector. The EBSD map was acquired using a spatial step size of 80 nm on a hexagonal grid. A size of zone in a single mapping is approximately 174.3 µm². A mean confidence index of the Kikuchi map during EBSD scanning was generally between 0.80 and 0.90. However, in the case of polycrystalline Cu films, the index was at a level of 0.7. Misorientation statistics were derived from an EBSD map using TSL OIM analysis v7 (Ametek, Inc). When the misorientation was greater than 1°, a segment between two adjacent points was considered as a boundary. In the misorientation map, boundaries with misorientation angles between 0 and 59° are indicated by blue lines corresponding to GBs, and boundaries with misorientation angles of 60° are indicated by red lines, which are associated with TBs of a face-centered cubic (FCC)(111) structure.

### Experimental Example 2: ARPES Measurement

High-resolution ARPES measurements were performed at beamline 4.0.3 of the Advanced Light Source (ALS). A Cu thin film was annealed under ultra-high vacuum at pressures above 5 x 10⁻¹⁰ Torr and measured at 10 K at pressures above 5 x 10⁻¹¹ Torr. The overall energy and angular resolution were set to higher than 20 meV and 0.1°, respectively.

### Experimental Example 3: Hall Measurement and Sample Preparation

A Hall bar device of a Cu thin film on a sapphire substrate was fabricated through e-beam lithography and wet etching using FeCl₃ solution. A general device channel length and width were 200 µm and 20 µm, respectively. Electrical transport measurements of Cu thin film devices were performed by TeslatronPT (Oxford) in a temperature range T = 1.5 to 300 K. A magnetic field (up to 12 Tesla) was applied along a direction perpendicular to the planar surface. A Keithley 4200 or 6221 current generator was used to apply a DC current to the device, and longitudinal (for resistivity and magnetoresistance) and transverse (for Hall) voltage differences were simultaneously measured using multiple Keithley 2182A voltmeters. The applied current was on the order of mA.

### Experimental Example 4: Comparison of polycrystalline and Single crystalline Samples

In order to compare polycrystalline and single crystalline samples, a polycrystalline thin film having a large number of GBs and a single crystalline thin film having different GB concentrations were prepared and compared.

In column 1, EBSD was measured for a 40 nm thick thin film, and in column 2, a number of GBs and a number of twin boundaries (hereinafter referred to as TBs) were measured by measuring misalignment lines, and in column 3, a result of measuring a Hall effect of each sample was presented. In addition, (a) is an experimental result for a polycrystalline thin film with a GB concentration above 10²/µm², and there is shown a single crystalline thin film grown using an ASE method by controlling the concentrations of 10¹/µm² (b), 10⁰/µm² (c), 10⁻¹/µm² (d), and 0 (e) formed by heat treatment at different temperatures.

Samples of (b) to (d) with significantly reduced GBs compared to the polycrystalline sample are perfectly aligned in a (111) direction in an out-of-plane direction, but some GBs (blue lines in column 2) are still present in an in-plane direction, and a most strongly nonlinear behavior is observed in a sample of (e) with completely disappeared GBs. Lines in red in column 2 are TBs, and since two adjacent orientations satisfy a symmetry, they do not have a noticeable effect on the motion of the electrons.

By means of the foregoing technical solutions, the present disclosure may solve the defects of general copper to lengthen a mean free path of electrons so as to change a structure of the Fermi surface where the existing electrons reside, thereby modifying an orbit of the electrons.

In addition, the present disclosure may manufacture a copper thin film provided to implement n-type and p-type characteristics using only copper by modifying a copper electron orbit.

As such, the foregoing technical configurations of the present disclosure will be understood by those skilled in the art that the foregoing present disclosure can be implemented in other specific forms without changing the technical concept and essential characteristics thereof.

Therefore, it should be understood that embodiments described above are merely illustrative but not restrictive in all aspects, and the scope of the present disclosure is defined by the appended claims rather than by the detailed description, and all changes or modifications derived from the meaning and range of the appended claims and equivalents thereof should be construed to be embraced by the scope of the present disclosure.

## Claims

1. A single crystalline copper thin film having a nonlinear Hall effect and a hole carrier dominant transport phenomenon in a two-dimensional single crystalline thin film with a suppressed grain boundary, the single crystalline copper thin film comprising:
a single crystalline copper thin film having a thickness of 200 nm or less,
wherein the single crystalline copper thin film has a suppressed grain boundary (GB).

2. The single crystalline copper thin film of claim 1, wherein the single crystalline copper thin film exhibits a nonlinear behavior of Hall resistance according to a magnetic field.

3. The single crystalline copper thin film of claim 1, wherein the single crystalline copper thin film is copper grown by atomic sputtering epitaxy (ASE) on a sapphire substrate.

4. A single crystalline copper thin-film semiconductor comprising:
a single crystalline copper thin film having a thickness of 200 nm or less,
wherein the single crystalline copper thin film has a suppressed GB, and
wherein electrical properties thereof are modified into p-type.

5. The single crystalline copper thin film semiconductor of claim 4, wherein the single crystalline copper thin film exhibits a nonlinear behavior of Hall resistance according to a magnetic field.

6. The single crystalline copper thin film semiconductor of claim 4, wherein the single crystalline copper thin film is copper grown by atomic sputtering epitaxy (ASE) on a sapphire substrate.

7. A method for manufacturing a single crystalline copper thin film having a nonlinear Hall effect and a hole carrier dominant transport phenomenon in a two-dimensional single crystalline thin film with a suppressed grain boundary, the method comprising:
performing RF sputtering on copper at 160 to 180° C to grow a copper thin film.

8. The method of claim 7, wherein an initial pressure of the RF sputtering is 2.0×10⁻³ to 2.5×10⁻³ Pa.

9. The method of claim 7, wherein the RF sputtering is performed in an Ar gas atmosphere.

10. The method of claim 7, wherein the RF sputtering controls the pressure by injecting Ar gas at 0.3 to 0.7 Pa.

11. The method of claim 7, wherein an RF power of the RF sputtering is 23 to 27 W.

12. The method of claim 7, wherein a rotational speed of the RF sputtering is 25 to 35 RPM.
